# EUROPÄISCHE PATENTANMELDUNG

(11) **EP 0 822 560 A2**
(43) Veröffentlichungstag der Anmeldung: **04.02.1998**
(21) Anmeldenummer: 97810447.9
(22) Anmeldetag: 07.07.1997
(51) Int. Cl.: H01B 12/02

(54) **Rohrförmige Hochtemperatursupraleiter-Anordnung**

(30) Priorität: 03.08.1996 DE 19631439
(71) Anmelder: ABB RESEARCH LTD., 8050 Zürich (CH)
(72) Erfinder: Lakner, Martin, Dr., 5413 Birmenstorf (CH); Paul, Willi, Dr., 5430 Wettingen (CH)
(74) Vertreter: Rzehak, Herbert

(57) **Zusammenfassung**

Hohlzylindrische Hochtemperatursupraleiter (6) werden zur induktiven Strombegrenzung eingesetzt. Bei einem Kurzschlußstrom durch den Hochtemperatursupraleiter (6) treten in diesem Vibrationen auf, die ohne Schutzmaßnahme zu einer Rißbildung der supraleitenden Keramik führen können. Um eine Rißbildung zu verhindern, wird der Hochtemperatursupraleiter (6) mit einem Stützwickel aus einem Faserverbundwerkstoff umwickelt, wodurch Zug- und Druckspannungen gleichmäßiger verteilt werden. Um diesen Stützwickel kann eine Dämpfungsschicht aus schwingungsdämpfender Watte oder Filz angebracht sein. Eine Unterteilung des supraleitenden Hohlzylinders in mehrere übereinander angeordnete kürzere Hohlzylinder gewährleistet deren einfachere Herstellung und höhere Belastbarkeit. Die Hochtemperatursupraleiter (6) sind in einer Halterung (10) aus einem Faserverbundwerkstoff unverspannt gelagert und über druckaufnehmende StapelTrennscheiben (14) an Spannstäben (11) mechanisch eingespannt.

## Beschreibung

### TECHNISCHES GEBIET

Bei der Erfindung wird ausgegangen von einer rohrförmigen Hochtemperatursupraleiter-Anordnung nach dem Oberbegriff des Patentanspruchs 1.

### STAND DER TECHNIK

Mit dem Oberbegriff des Patentanspruchs 1 nimmt die Erfindung auf einen Stand der Technik Bezug, wie er aus der DE 4 418 050 Al bekannt ist. Dort ist ein hohlzylindrischer Hochtemperatursupraleiter, der zur induktiven Strombegrenzung eingesetzt wird, außen und/oder innen mit einer 1 µm dicken Leitsilberschicht überzogen, auf welche eine 10 µm dicke Metallschicht aus Silber oder Aluminium aufgebracht sein kann. Um Zugspannungen in der Keramik des Hohlzylinders zu vermeiden und den elektrischen Übergangswiderstand der Metallschichten zu verringern, wird dieser Hohlzylinder unter einer Zugspannung mit einer mechanischen Armierung aus einem elastischen Stahldraht oder aus Glasfasergewebe umwickelt und dieser Wickel durch ein Lot oder ein kältebeständiges Kunstharz fixiert. Dadurch bleibt der Hohlzylinder unter einem kompressiven Druck.

Bei einem Kurzschlußstrom ist der Hochtemperatursupraleiter mechanischen Belastungen ausgesetzt, die zu einer Rißbildung der supraleitenden Keramik führen können. Ursachen für eine Rißbildung können sein:
1. elektromagnetische Kräfte zwischen dem Magnetfeld einer Spule und dem Strom im Hochtemperatursupraleiter,
2. Stöße durch schlagartig verdampfenden Stickstoff und
3. Vibrationen, welche ihre Ursachen in magnetischen Kräften zwischen Spule und Eisenkern haben und über die Aufhängung der supraleitenden Teile auf die supraleitende Keramik übertragen werden.

Zum einschlägigen Stand der Technik wird zusätzlich auf die DE 41 07 685 A1 verwiesen, aus der es bekannt ist, mehrere induktivitätsarme, supraleitende Strombegrenzer, die elektrisch in Reihe geschaltet sind, zu stapeln.

### DARSTELLUNG DER ERFINDUNG

Die Erfindung, wie sie im Patentanspruch 1 definiert ist, löst die Aufgabe, eine rohrförmige Hochtemperatursupraleiter-Anordnung der eingangs genannten Art derart weiterzuentwickeln, daß Rißbildungen vermieden werden.

Vorteilhafte Ausgestaltungen der Erfindung sind in den abhängigen Patentansprüchen definiert.

Ein Vorteil der Erfindung besteht darin, daß die Lebensdauer von Hochtemperatursupraleitern verlängert und deren Störanfälligkeit somit verringert wird.

Eine Verstärkung der Hochtemperatursupraleiter mit Faserverbundwerkstoffen führt zu einer gleichmäßigeren Verteilung von Zug- und Druckspannungen in der Keramik der Hochtemperatursupraleiter. Eine Unterteilung des supraleitenden Hohlzylinders in mehrere übereinander angeordnete kürzere Hohlzylinder gewährleistet eine einfachere Herstellung der Hochtemperatursupraleiter und eine höhere Belastbarkeit derselben.

Gemäß einer vorteilhaften Ausgestaltung der Erfindung können supraleitende Teile schwingungsgedämpft aufgehängt sein.

### KURZE BESCHREIBUNG DER ZEICHNUNGEN

Die Erfindung wird nachstehend anhand von Ausführungsbeispielen erläutert. Es zeigen:
- Fig. 1: einen Querschnitt durch einen vibrationsgedämpft gelagerten hohlzylindrischen Hochtemperatursupraleiter in einem Kryostaten, der einen weichmagnetischen Kern umgibt und
- Fig. 2 und 3: unterschiedliche Stapelanordnungen von Hochtemperatursupraleitern.

### WEGE ZUR AUSFÜHRUNG DER ERFINDUNG

In den Figuren sind gleiche Teile mit gleichen Bezugszeichen gekennzeichnet.

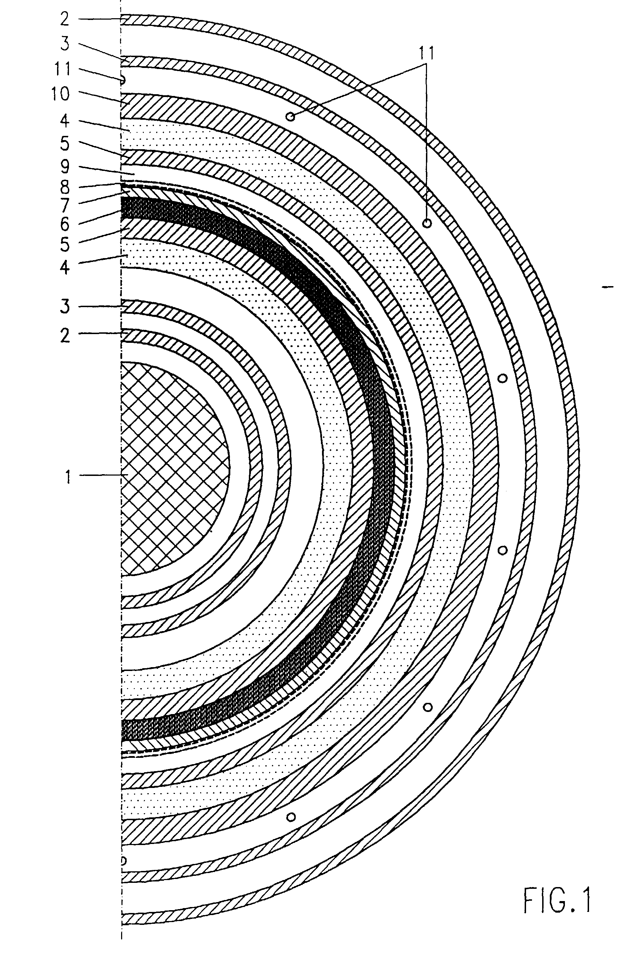

Fig. 1 zeigt in einem nicht maßstabsgetreuen teilweisen Querschnitt einen schwingungsgedämpft gelagerten, hohlzylindrischen, keramischen Hochtemperatursupraleiter (6) innerhalb eines Kryostaten (2, 3), der einen zentralen Magnetkern (1) aus einem weichmagnetischen Werkstoff bzw. einen Transformatorkern umgibt. Der Kryostat (2, 3) weist eine Kryostat-Außenwandung (2) aus einem elektrisch isolierenden Faserverbundwerkstoff auf, welche deckel- und bodenseitig (nicht dargestellt) mit einer Kryostat-Innenwandung (3) verbunden ist. Zwischen Kryostat-Außenwandung (2) und Kryostat-Innenwandung (3) befindet sich Vakuum und Superisolation.

Auf den hohlzylindrischen Hochtemperatursupraleiter (6) ist außenseitig als elektrische Stabilisierung eine etwa 1 um dicke Metallschicht, vorzugsweise eine Silberschicht (7) aus einer Leitsilberpaste, aufgebracht und darauf unter Zugspannung eine mechanische Armierung (8), vorzugsweise aus Stahldraht, gewickelt, die mit einem elektrisch gutleitenden Fixiermittel (9), vorzugsweise aus einem silbergefüllten Zweikomponentenepoxidharz, fixiert ist. Die Armierung (8) dient zur Erzeugung eines kompressiven Druckes auf den Hochtemperatursupraleiter (6) und unterstützt die elektrische Stabilisierung. Das so entstandene rohrförmige Teil (6 - 9) ist mit einer 200 um dicken Schicht bzw. einem imprägnierten Stützwickel (5) aus einem elektrisch isolierenden Faserverbundwerkstoff, vorzugsweise aus einem glas- und/oder kohlenfaserverstärkten Kunstharz umwickelt. Der Faserverbundwerkstoff (5) wird im nichtgehärteten Zustand gewickelt und nach dem Wickeln gehärtet; er stabilisiert dann den Hochtemperatursupraleiter (6) mechanisch. Der so entstandene Verbund aus Hochtemperatursupraleiter (6), mechanischer Armierung (8) und Fixiermittel (9) wird anschließend allseitig mit einer Dämpfungsschicht (4) aus einem schwingungsdämpfenden Material, vorzugsweise aus Baumwolle, Filz oder Watte, umwickelt. Außenseitig ist diese Dämpfungsschicht (4) von einer rohrförmigen Halterung (10) aus einem elektrisch isolierenden Faserverbundwerkstoff umgeben, innenseitig von flüssigem Stickstoff. Außenseitig sind um die Halterung (10) in vorgebbaren Winkelabständen Spannstäbe (11) aus Stahl oder aus einem Faserverbundwerkstoff mit einem Durchmesser von vorzugsweise 3 mm angeordnet, die ebenfalls in flüssigem Stickstoff gelagert sind.

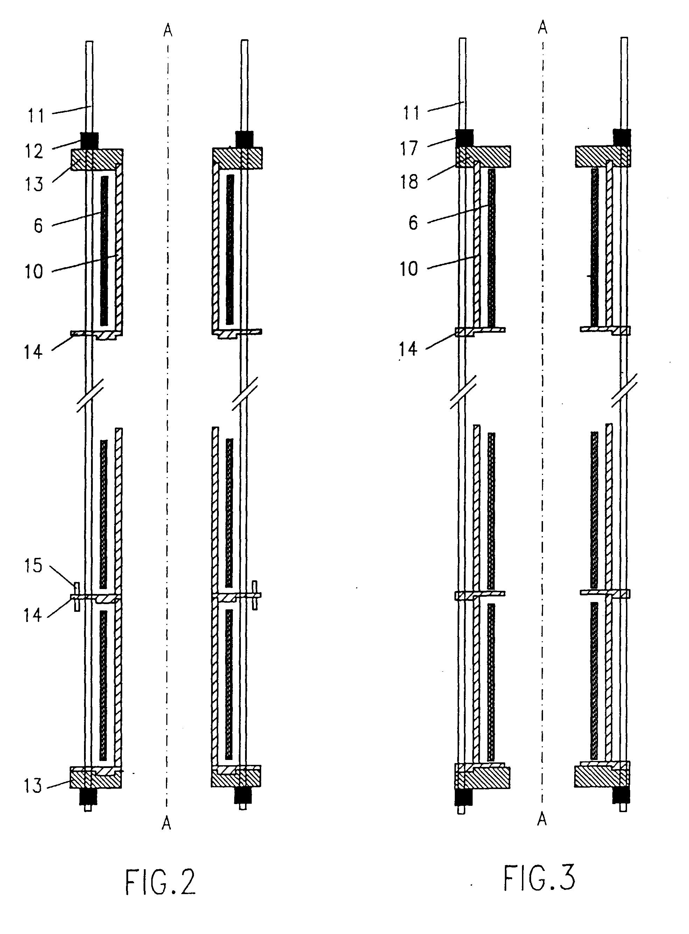

Die Fig. 2 und 3 zeigen Stapelanordnungen mit mehreren übereinander gelagerten Hochtemperatursupraleitern (6), wobei der Übersichtlichkeit wegen die Kryostaten (2, 3), die Magnetkerne (1) und die mechanische Armierung (8), die Fixiermittel (9), die Stützwickel (5) und die Dämpfungsschicht (4) gemäß Fig. 1 weggelassen wurden. Zwischen übereinanderliegenden Halterungen (10) sind Stapel-Trennscheiben (14) aus einem Faserverbundwerkstoff angeordnet; sie begrenzen die vertikale Bewegungsmöglichkeit der Hochtemperatursupraleiter (6), die über ihre Dämpfungsschicht (4) (nicht dargestellt) an angrenzenden Stapel-Trennscheiben (14) anliegen. Jeder Stapel mit mehreren Hochtemperatursupraleitern (6) weist endseitig Spannringe (13) auf, die mittels Spannmuttern (12) an den Spannstäben (11) eingespannt sind. Mit (A) ist jeweils eine Zentralachse der Hohlzylinder bezeichnet.

Fig. 3 zeigt eine Anordnung von Hochtemperatursupraleiter (6), Halterung (10) und Spannstäben (11) gemäß Fig. 1. Der Hochtemperatursupraleiter (6) kann jedoch auch zwischen Halterung (10) und Spannstab (11) angeordnet sein, wie es in Fig. 2 dargestellt ist.

Wichtig ist, daß die Kühlung des Hochtemperatursupraleiters (6) durch den Stützwickel (5) aus dem Faserverbundwerkstoff nicht wesentlich beeinträchtigt wird. Die Wandstärke des Stützwickels (5) muß so gewählt werden, daß die Temperaturerhöhung der supraleitenden Teile, die bei einer Wechselstromanwendung aus im Hochtemperatursupraleiter (6) anfallenden elektrischen Verlusten resultiert, kleiner als 1 K bleibt. Die mit der Temperaturerhöhung einhergehende Reduktion der Stromtragfähigkeit soll kleiner als 20 % sein.

Mit einer typischen spezifischen Wärmeleitfähigkeit von 2 mW/K·cm für Glasfaserepoxidharz bei 77 K und einer Wechselstromverlustleistung von 0,5 W/cm³ Hochtemperatursupraleiter (6) ergibt sich eine Temperaturerhöhung von etwa 100 mK/mm Schichtdicke des Stützwickels (5). Um sowohl eine ausreichende Kühlung als auch eine genügende mechanische Stabilisierung zu gewährleisten, kann die Schichtdicke des Stützwickels (5) an der Innen- und Außenseite des Hochtemperatursupraleiters (6) unterschiedlich gewählt werden. Es können auch Faserverbundwerkstoffe mit offener Struktur verwendet werden. Dabei ist darauf zu achten, daß insbesondere die Ränder des Hochtemperatursupraleiters (6) mit einer durchgehenden mechanischen Armierung (5) versehen werden.

Durch das Aufbringen des Stützwickels (5) auf den Hochtemperatursupraleiter (6) können unerwünschte Hohlräume entstehen. Falls diese nicht absolut dicht sind, werden sie sich mit flüssigem Stickstoff füllen. Da sich im Falle eines Kurzschlußstromes der Hochtemperatursupraleiter (6) sehr schnell erwärmt, wird der Stickstoff explosionsartig verdampfen und möglicherweise den Stützwickel (5) zerstören. Zur Vermeidung dieser Schäden können folgende Maßnahmen ergriffen werden:
1. Abdichten des Stützwickels (5) durch Verwendung eines hinreichend dichten Faserverbundwerkstoffes oder durch Beschichten eines nicht dichten Faserverbundwerkstoffes mit einem dünnen, stickstoffundurchlässigen Film, z. B. aus Silikon oder Polyimid;
2. Verwendung eines Faserverbundwerkstoffes mit offener Struktur, wodurch die Bildung von Hohlräumen vermieden wird;
3. Verwendung eines Vakuum-Druckimprägnierverfahrens, wodurch Zwischenräume im Stützwickel (5) ausgefüllt werden.

Bei der Wahl des Materials der Dämpfungsschicht (4), das zur Vibrationsdämpfung der Hochtemperatursupraleiter (6) verwendet wird, ist zu beachten, daß sich dessen Elastizität beim Abkühlen auf 77 K ändert. Zur Dämpfung geeignet sind daher Materialien wie Filz oder Watte, die aus einem Geflecht oder Gewebe von einzelnen Fasern bestehen. Deren Dämpfungseigenschaften werden dann auch von dem in die Dämpfungsschicht (4) eingedrungenen flüssigen Stickstoff mitbestimmt.

### Beispiel 1:

Der supraleitende Hohlzylinder zur magnetischen Abschirmung des Magnetkerns (1) setzt sich aus 16 übereinander angeordneten Hochtemperatursupraleiter-Ringen (6) gemäß den Fig. 2 oder 3 zusammen. Diese 16 Hochtemperatursupraleiter-Ringe (6) werden mit Hilfe von Halterungen (10) und Stapel-Trennscheiben (14) aus Glasfaserepoxidharz übereinandergestapelt. Jeder Hochtemperatursupraleiter-Ring (6) ist außer mit der Armierung, wie sie in der eingangs genannten DE 4 418 050 Al und in Verbindung mit Fig. 1 beschrieben ist, zusätzlich mit dem Stützwickel (5) verstärkt. Die einzelnen Formteile bzw. Halterungen (10) und Stapel-Trennscheiben (14) werden mit Stahl- oder Spannstäben (11) aus einem Faserverbundwerkstoff gegeneinander verspannt. Die Spannstäbe (11) können an der Außenseite der Hochtemperatursupraleiter-Ringe (6) angebracht sein, wie in den Fig. 2 und 3 dargestellt, sie können jedoch auch entlang deren Innenseite montiert sein (nicht dargestellt). Die Halterungen (10) können einen kleineren Durchmesser haben als die Hochtemperatursupraleiter-Ringe (6), wie in Fig. 2 dargestellt; sie können jedoch auch einen größeren Durchmesser haben, wie in Fig. 3 dargestellt.

### Beispiel 2:

Die im Beispiel 1 beschriebenen, mit einem Stützwickel (5) versehenen Hochtemperatursupraleiter-Ringe (6) sind zusätzlich mit einer Lage oder mit 2 Lagen Filz (4) umwickelt. Dadurch können Schläge oder Vibrationen, die durch magnetische, auf die Hochtemperatursupraleiter-Ringe (6) einwirkende Kräfte entstehen, nur stark gedämpft auf deren Aufhängung (10) übertragen werden.

### Beispiel 3:

Die im Beispiel 1 beschriebenen, mit einem Stützwickel (5) versehenen Hochtemperatursupraleiter-Ringe (6) sind zusätzlich mit einem Kunstharz oder mit einem Silikonthermoplast mit der Halterung (10) vergossen (nicht dargestellt). Der resultierende Verbund gewährleistet eine genügende mechanische Stabilität, so daß Schläge und/oder Vibrationen, denen dieser Verbund ausgesetzt ist, im Hochtemperatursupraleiter (6) keine Rißbildung verursachen.

### Beispiel 4:

Die Hochtemperatursupraleiter-Ringe (6) können gemäß den Beispielen 1 - 3 ausgeführt und angeordnet sein. Zusätzlich ist jedoch zwischen benachbart übereinander angeordneten Hochtemperatursupraleiter-Ringen (6) ein elektrisch leitendes Band (15) aus Bronze oder Messing vorgesehen, das den Zwischenraum zwischen 2 Ringen überdeckt und an den Stapel-Trennscheiben (14) befestigt ist, wie es in Fig. 2 zwischen den beiden unteren Hochtemperatursupraleiter-Ringen (6) angedeutet ist. Durch dieses Band wird die Radialkomponente des während eines Kurzschlußstromes auftretenden Magnetfeldes deutlich verringert. Bei der Wahl des Materials des Bandes (15) ist darauf zu achten, daß dessen elektrischer Widerstand nicht deutlich größer als derjenige der elektrischen Stabilisierung (7) der Hochtemperatursupraleiter-Ringe (6) ist. Diese Bänder (15) können entfallen, wenn elektrisch leitende Stapel-Trennscheiben (14) verwendet werden.

### BEZEICHNUNGSLISTE

- 1: Magnetkern aus weichmagnetischem Werkstoff, Transformatorkern
- 2: Kryostat-Außenwandung aus Faserverbundwerkstoff
- 3: Kryostat-Innenwandung aus Faserverbundwerkstoff
- 4: Dämpfungsschicht, schwingungsdämpfende Schicht, Baumwolle, Filz, Watte,
- 5: Stützwickel, Wickel aus Faserverbundwerkstoff, insbesondere aus glas- oder kohlefaserverstärktem Kunststoff/Epoxidharz
- 6: hohlzylindrischer Hochtemperatursupraleiter Hochtemperatursupraleiter-Ringe
- 7: Silberschicht, elektrische Stabilisierung
- 8: elastischer Metalldraht, Stahldraht, mechanische Armierung
- 9: elektrisch leitendes Fixiermittel, Lot, Kunstharz
- 10: Halterung aus Faserverbundwerkstoff, Aufhängung, druckaufnehmendes Element
- 11: Spannstab aus Stahl oder Faserverbundwerkstoff
- 12: Spannmutter
- 13: Spannring
- 14: Stapel-Trennscheibe aus Faserverbundwerkstoff, druckaufnehmendes Element
- 15: elektrisch leitendes Band

- A: Zentralachse

## Patentansprüche

1. Rohrförmige Hochtemperatursupraleiter-Anordnung
a) mit mindestens einem hohlzylindrischen Hochtemperatursupraleiter (6),
b) der auf mindestens einer seiner beiden Zylinderflächen mindestens eine metallische, nicht supraleitende elektrische Stabilisierung (7 - 9) und
c) mindestens eine erste mechanische Armierung (8, 9) aufweist,
dadurch gekennzeichnet,
d) daß der mindestens eine Hochtemperatursupraleiter (6) zusätzlich, zumindest innenseitig, eine zweite mechanische Armierung (5) aus einem Faserverbundwerkstoff aufweist, welche mit dem Hochtemperatursupraleiter (6) einen festen Verbund bildet.

2. Rohrförmige Hochtemperatursupraleiter-Anordnung nach Anspruch 1, dadurch gekennzeichnet,
a) daß der Faserverbundwerkstoff der zweiten mechanischen Armierung (5) elektrisch isolierend ist und
b) Glasfasern und/oder
c) Kohlefasern enthält.

3. Rohrförmige Hochtemperatursupraleiter-Anordnung nach einem der vorhergehenden Ansprüche, dadurch gekennzeichnet, daß der mindestens eine Hochtemperatursupraleiter (6) zusätzlich eine dritte, nicht metallisch leitende mechanische Armierung (4) mit einem schwingungsdämpfenden Material aufweist.

4. Rohrförmige Hochtemperatursupraleiter-Anordnung nach Anspruch 3, dadurch gekennzeichnet,
a) daß das schwingungsdämpfende Material der dritten mechanischen Armierung (4) Baumwolle und/oder
b) Filz und/oder
c) Watte enthält.

5. Rohrförmige Hochtemperatursupraleiter-Anordnung nach einem der vorhergehenden Ansprüche, dadurch gekennzeichnet,
a) daß mehrere hohlzylindrische Hochtemperatursupraleiter (6) übereinander in einem Stapel angeordnet und
b) gegenseitig durch druckaufnehmende Elemente (10, 14) getrennt sind.

6. Rohrförmige Hochtemperatursupraleiter-Anordnung nach Anspruch 5, dadurch gekennzeichnet,
a) daß jeder Hochtemperatursupraleiter (6) in einer Halterung (10) aus einem Faserverbundwerkstoff mechanisch spannungsfrei gelagert ist und
b) daß die Halterungen (10) zusammen mit den Stapel-Trennscheiben (14) in dem Stapel mechanisch verspannt sind.

7. Rohrförmige Hochtemperatursupraleiter-Anordnung nach einem der Ansprüche 5 oder 6, dadurch gekennzeichnet, daß zwischen dem Hochtemperatursupraleiter (6) und der Stapel-Trennscheibe (14) ein elektrisch leitendes Band (15) angeordnet ist.

8. Rohrförmige Hochtemperatursupraleiter-Anordnung nach einem der Ansprüche 1 oder 2, dadurch gekennzeichnet, daß die zweite mechanische Armierung (5) über ein Kunstharz oder über einen Silikonthermoplastwerkstoff mit einer Halterung (10) für den Hochtemperatursupraleiter (6) fest verbunden ist.
